(19) Europäisches Patentamt

European Patent Office

Office européen des brevets

(11) Veröffentlichungsnummer : **0 213 354 B1**

# (12) EUROPÄISCHE PATENTSCHRIFT

(45) Veröffentlichungstag der Patentschrift :
**30.01.91 Patentblatt 91/05**

(21) Anmeldenummer : **86109796.2**

(22) Anmeldetag : **17.07.86**

(51) Int. Cl.⁵ : **H03F 1/54, H03F 3/24**

(54) Schutzeinrichtung gegen Überschläge in einer Senderschaltung.

(30) Priorität : **28.08.85 DE 3530677**

(43) Veröffentlichungstag der Anmeldung :
**11.03.87 Patentblatt 87/11**

(45) Bekanntmachung des Hinweises auf die
Patenterteilung :
**30.01.91 Patentblatt 91/05**

(84) Benannte Vertragsstaaten :
**CH DE FR GB LI**

(56) Entgegenhaltungen :
**DE-A- 2 834 072**
**DE-B- 1 242 720**
**ELEKTROTECHNISCHE ZEITSCHRIFT, Band**
**21, Nr. 3, 7. Februar 1969, Seiten 54-58, Berlin,**
**DE; P.G. ZEHNEL et al.: "Schutzeinrichtungen**
**für Hochleistungs-Senderröhren bei inneren**
**Überschlägen"**

(73) Patentinhaber : **Licentia**
**Patent-Verwaltungs-GmbH**
**Theodor-Stern-Kai 1**
**D-6000 Frankfurt/Main 70 (DE)**

(72) Erfinder : **Beeken, Horst, Dipl.-Ing.**
**Teltower-Strasse 14**
**D-1000 Berlin 20 (DE)**
Erfinder : **Vitters, Hans-Heinrich, Dipl.-Ing.**
**Hocksteinweg 2a**
**D-1000 Berlin 37 (DE)**

(74) Vertreter : **Schulze, Harald Rudolf, Dipl.-Ing.**
**Licentia Patent-Verwaltungs-GmbH**
**Theodor-Stern-Kai 1**
**D-6000 Frankfurt/Main 70 (DE)**

**Beschreibung**

Die Erfindung betrifft eine Schutzeinrichtung gegen Überschläge in einer Senderschaltung nach dem Oberbegriff des Patentanspruchs 1.

Aus der DE-OS 28 34 029 sowie aus der DE-PS 28 33 992 ist eine derartige Schutzeinrichtung bekannt, bei der bei einem Rundfunksender eine zu schützende Schaltung, z.B. bestehend aus einer Schalt- sowie Endstufenröhre und einer Freilaufdiode durch Parallelschalten einer zündbaren Entladungsstrecke, z.B. eines Ignitrons, geschützt wird. Die Entladungsstrecke wird mit Hilfe einer Zündschaltung gezündet, wenn in der zu schützenden Schaltung eine unerwünschte Überspannung auftritt.

Wird nun ein derartiger Rundfunksender z.B. als pulsdauermodulierter Hochleistungssender mit einer beispielhaften Ausgangsleistung von ungefähr 600kW ausgebildet, so ist an der zu schützenden Schaltung eine Gleichspannung von ungefähr 30 kV erforderlich. Eine dazu parallel geschaltete Entladungsstrecke sollte im nicht gezündeten Zustand eine höhere Spannungsfestigkeit besitzten, damit keine Störungen durch unbegründetes Zünden der Entladungsstrecke enstehen.

Für die zündbare Entladungsstrecke verwendbare Ignitrons können derzeit im ungezündeten Zustand lediglich einer maximalen Gleichspannung von ungefähr 50 kV bei einer Umgebungstemperatur von 20°C widerstehen. Diese maximale Gleichspannung verringert sich aufgrund physikalischer Eigenschaften (Derating) auf einen Wert von ungefähr 35 kV bei einer Umgebungstemperatur von ungefähr 45°C. Da eine solche Umgebungstemperatur insbesondere bei einem Betrieb des Senders in tropischen Ländern auftritt, ist dann der Sicherheitsabstand von ungefähr 5 kV zur Dauerbetriebsspannung (30 kV) zu gering.

Kleine transiente Überspannungen, die beim Sendebetrieb unvermeidbar sind, würden in störender Weise zu einem sogenannten Über-Kopf-Zünden des Ignitrons führen, das heißt, es erfolgt ein Zünden über die Anoden-Kathodenstrecke unter Umgehung der Zündelektrode, des sogenannten Zündstiftes.

Zur Vermeidung eines derartigen Nachteils ist es naheliegend, das Ignitron entsprechend zu kühlen. Dafür ist aber insbesondere in tropischen Ländern eine kostenungünstige Klimaanlage erforderlich. Es ist weiterhin naheliegend, mindestens zwei Ignitrons in Reihe zu schalten und diese durch mindestens eine Zündschaltung zu zünden. Dabei ist jedoch zu beachten, daß mindestens eines der Ignitrons im nichtgezündeten Zustand auf Hochspannungspotential liegt. Die Zündschaltung müßte daher ebenfalls eine entsprechende Spannungsfestigkeit besitzen. Eine solche Zündschaltung ist jedoch unwirtschaftlich.

Aus der DE-OS 1242720 ist eine Schutzschaltung nach dem Oberbegriff des Anspruchs 1 bekannt.

Der Nachteil dieser Schaltung besteht darin, daß die Schaltung sich nicht selbsttätig überwacht.

Der Erfindung liegt daher die Aufgabe zugrunde, eine gattungsgemäße Schutzeinrichtung anzugeben, die in kostengünstiger sowie zuverlässiger Weise einen Schutz gegen störende Überspannungen an der zu schützenden Schaltung ermöglicht und die sich selbst überwacht, das heißt, ein unbeabsichtigtes Zünden einer beliebigen Entladungsstrecke innerhalb der Reihenschaltung der Entladungsstrecken führt selbsttätig zu einem Zünden aller Entladungsstrecken, so daß einerseits eine mögliche Überspannung abgebaut wird und andererseits wieder der ursprüngliche Ausgangszustand hergestellt wird, der für ein beabsichtigtes Zünden der Entladungsstrecken erforderlich ist.

Diese Aufgabe wird gelöst durch die im kennzeichnenden Teil des Patentanspruchs 1 angegebenen Merkmale. Vorteilhafte Ausgestaltungen und/oder Weiterbildungen sind den Unteransprüchen entnehmbar.

Die Erfindung wird im folgenden anhand von Ausführungsbei- spielen näher erläutert unter Bezugnahme auf eine schematische Zeichnung. Die

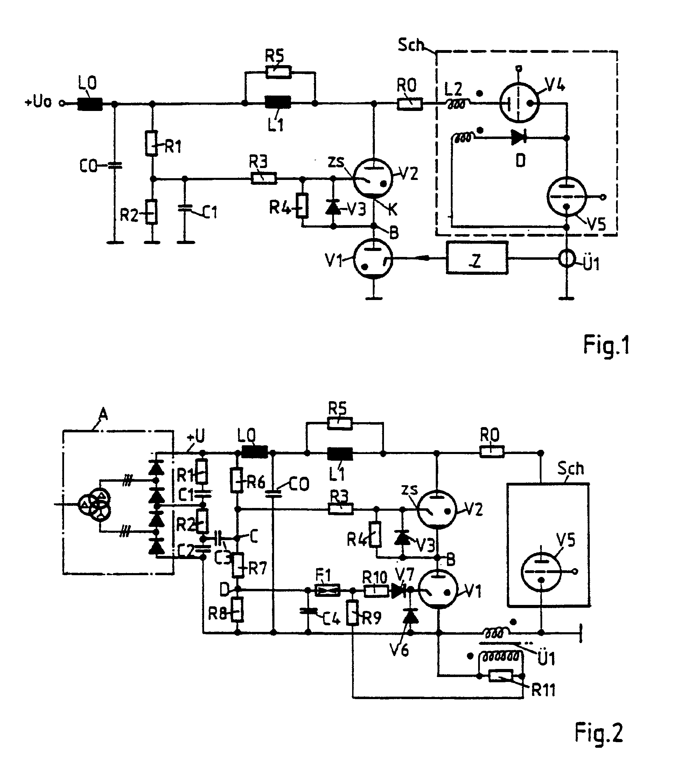

Fig. 1 bis 3 zeigen schematische Darstellungen von drei Ausführungsbeispielen.

Fig. 1 zeigt eine Gleichspannung +U, z.B. 30 kV, die durch die Induktivität LO und den Kondensator CO geglättet wird, der im wesentlichen parallel zu der zu schützenden Schaltung Sch liegt. Diese enthält z.B. bei einem pulsdauermodulierten Sender eine Endstufenröhre V5, eine Schaltröhre V4, eine Freilaufdiode D sowie eine Speicherspule L2. Die zwischen dem Kondensator CO und der Schaltung Sch liegenden Bauelemente RO, R5 sowie L1 haben vernachlässigbare Werte, so daß ein Spannungsüberschlag in den Röhren V4, V5 zu einem Entladungsvorgang des Kondansators CO führt. Dieser besitzt eine Kapazität von beispielsweise 60 μF, sodaß die darin gespeicherte Energie zu einer Zerstörung der Schaltung Sch führen würde. Zum Schutz der Schaltung Sch ist daher parallel zu dieser eine Reihenschaltung von zwei zündbaren Entladungsstrecken V1, V2, z.B. Ignitrons geschaltet. Bei einem Überschlag in der Schaltung Sch werden die Entladungsstrecken V1, V2 mit Hilfe eines Übertragers Ü1 sowie einer einzigen Zündschaltung Z gezündet, so daß die in dem Kondensator CO gespeicherte Ladung über die strombegrenzenden Bauelemente R5, L1 und die gezündeten Entladungsstrecken V1, V2 abfließt.

In der Schaltung Sch gespeicherte Ladung wird dabei gleichzeitig über den strombegrenzenden Widerstand RO abgebaut. Der Zündvorgang wird nachfolgend näher erläutert.

Bei ungezündeter erster bzw. weiterer Entladungsstrecke V1 bzw. V2 legt der ohmsche Spannungsteiler R1, R2 über die ohmschen Widerstände R3, R4 den Zündstift ZS, die Kathode der weiteren Entladungsstrecke V2 und die Anode der ersten Entladungsstrecke V1 auf die halbe Betriebsspannung +U/2, z.B. 15 kV.

Bei einem Spannungsüberschlag in der Schaltung Sch, z.B. in den Röhren V4, V5, aktiviert der zwischen Kathode der Röhre V5 und Masse (Erdpotential) angeschlossene Übertrager Ü1 die Zündschaltung Z, welche die erste Entladungsstrecke V1 zündet, deren Kathode ebenfalls mit Masse verbunden ist. Dadurch wird Punkt B (Kathode der weiteren Entladungsstrecke V2) auf Masse gezogen. Dadurch entlädt sich ein Kondensator, der Zündenergiespeicher C1, über die ohmschen Widerstände R3, R4 sowie die erste Entladungsstrecke V1. Dieser Entladevorgang liefert die zum Zünden der weiteren Entladungsstrecke V2 erforderliche Zündenergie. Es fließt ein Zündstrom, der durch den Zündstrombegrenzer R3 (ohmscher Widerstand) begrenzt wird. Dabei verhindert die zwischen Zündstift ZS und Kathode K der weiteren EntladungsstreckeV2 geschaltete Diode V3 störende negative Spannungen am Zündstift ZS bezüglich der zugehörigen Kathode K. Durch den Spannungsabfall an dem Widerstand R4 entsteht die zum Zünden der weiteren Entladungsstrecke V2 erforderliche Zündspannung zwischen Zündstift ZS und zugehörigen Kathode K und die weitere Entladungsstrecke V2 zündet ebenfalls. Die Zündenergie wird begrenzt durch die Kapazität des Zündenergiespeichers C1. Der nachfolgende Gleichstrom wird durch den Widerstand R1 begrenzt.

Durch die derart gezündeten Entladungsstrecken V1, V2 entsteht für die zur Betriebsspannung +U gehörende Spannungsquelle, den Kondensator Co sowie die Schaltung Sch ein Kurzschluß, über den störende Überspannungen abgebaut werden. Dabei verhindert die Parallelschaltung des Widerstandes R5 und der Induktivität L1 ein vorzeitiges Erlöschen der gezündeten Entladungsstrecken V1, V2. Die Wirkungsweise dieses Vorganges ist in der eingangs erwähnten DE-OS 28 34 029 näher beschrieben. Es ist also vorteilhafterweise lediglich eine einzige Zündschaltung ZS erforderlich, die auf einem niedrigen Potential liegt und die lediglich die für die erste Entladungsstrecke V1 erforderliche Zündung bewirkt.

Fig. 2 zeigt ein zweites Ausführungsbeispiel, bei dem ein Zwölf-Puls-Hochspannungsgleichrichter A eine beispielhafte Betriebsspannung +U von 30 kV erzeugt, die über die Induktivität LO und den Kondensator CO geglättet und der Schaltung Sch zugeführt wird. Die Schaltung Sch entspricht derjenigen der Fig. 1. Die an der Betriebsspannung +U liegende RC-Kette R1, C1/R2,C2 dient zum Schutz der in dem Hochspannungsgleichrichter A vorhandenen Gleichrichterdioden gegen störende transiente Überspannungen. Der Punkt B wird durch den Spannungsteiler R6, R7, R8 auf die halbe Betriebsspannung +U/2 gelegt, wie in Fig. 1. Im folgenden wird die Zündschaltung Z, die auch in dem Ausführungsbeispiel gemäß Fig. 1 verwendbar ist, näher erläutert. Tritt in der Schaltung Sch der bereits erwähnte Spannungsüberschlag auf, z.B. in der Röhre V5, wird durch den mit dem Abschlußwiderstand R11 abgeschlossenen Übertrager Ü1 sowie den Widerstand R9 eine negative Spannung an den durch den Kondensator C4 sowie den Spannungsteilerwiderstand R8 positiv vorgespannten Schwellwertschalter F1, vorzugsweise eine Funkenstrecke, gelegt, der dann durchschaltet (durchzündet). Der Kondensator C4 entlädt sich dann über den Schwellwertschalter F1, den Strombegrenzerwiderstand R10 sowie die Diode V7 auf den Zündstift der ersten Entladungsstrecke V1, z.B. vorzugweise ein Ignitron, die durchzündet. Die Dioden V6, V7 sorgen dafür, daß der Zündstift lediglich eine positive Spannung erhält bezüglich der zugehörigen Kathode. Punkt B wird im wesentlichen auf Massepotential gezogen, da an der Primärwicklung des Übertragers Ü1 lediglich ein vernachlässigbarer Spannungsabfall auftritt. Der vorher nicht aufgeladene Kondensator C3 wird nun über die Bauelemente R3, R4, V1 sowie C2 stoßartig geladen. Der Kondensator C3 dient für die weitere Entladungsstrecke V2, vorzugsweise ebenfalls ein Ignitron, als Zündenergiespeicher, dessen Ladestrom an dem Widerstand R4 einen derartigen Spannungsabfall erzeugt, daß die weitere Entladungsstrecke V2 durchzündet. Damit ist die gleiche Wirkung erreicht wie in Fig. 1 beschrieben.

Anhand der Fig. 2 wird nun die erwähnte vorteilhafte Eigenüberwachung erläutert, die in analoger Weise auf das Ausführungsbeispiel gemäß Fig. 1 anwendbar ist. Zündet die erste Entladungsstrecke V1 ungewollt über Kopf, das heißt über die Anoden-Kathodenstrecke, z.B. infolge eines Hochspannungspulses, so läuft der vorstehend beschriebene Zündvorgang ab. Zündet dagegen die weitere Entladungsstrecke V2 ungewollt, so wird Punkt B auf ein Potential von ungefähr 30 kV (Betriebsspannung) angehoben, desgleichen auch Punkt C. Dieses erfolgt über die Bauelemente V3/R4 sowie R3. Punkt D wird über den Widerstand R7 auf die doppelte positive Spannung angehoben, so daß der Schwellwertschalter F1 zündet. Der Kondensator C4 entlädt sich und zündet in beschriebener Weise die erste Entladungsstrecke V1.

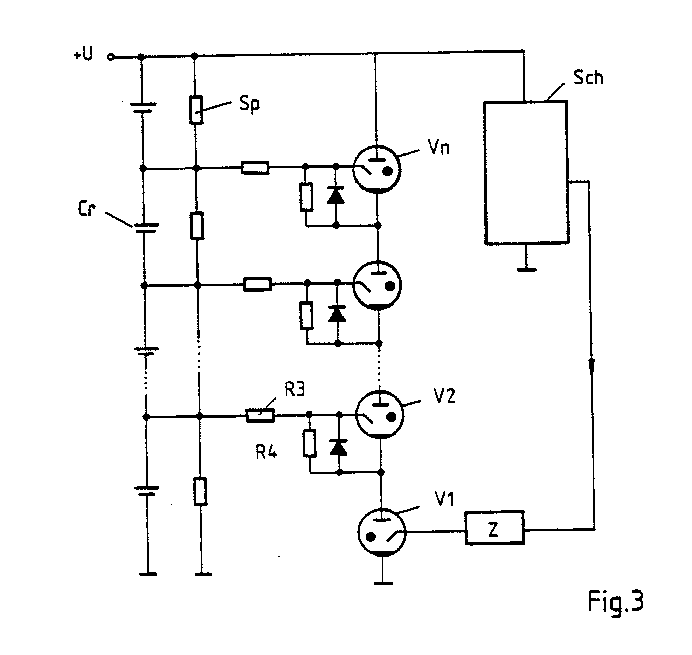

Fig. 3 zeigt in schematischer Weise ein Ausführungsbeispiel mit einer Reihenschaltung aus mehreren Entladungsstrecken V1 bis Vn. z.B. Ignitrons, die parallel zu der zu schützenden Schaltung Sch geschaltet ist. Der Zündvorgang läuft sinngemäß zu den bereits beschriebenen Ausführungsbeispielen ab. Über die Zündschaltung Z wird lediglich die erste Entladungsstrecke V1 gezündet. Der ohmsche Spannungsteiler Sp erzeugt die erforderlichen Zündspannungen für die Entladungsstrecken V1 bis Vn, die Reihenschaltung Cr von Kondensatoren erzeugt die jeweils erforderliche Zündenergie.

Die Erfindung ist nicht auf die beschriebenen Ausführungsbeispiele beschränkt, sondern sinngemäß auf weitere anwendbar. Beispielsweise ist es möglich, den in Fig. 2 erwähnten Schwellwertschalter F1 als Thyristor mit einer entsprechenden Ansteuerschaltung auszubilden.

**Ansprüche**

1. Schutzeinrichtung gegen Überschläge in einer Senderschaltung, bei welcher
— zu einer zu schützenden Schaltung in einem Parallelzweig eine zündbare erste Entladungsstrecke geschaltet ist, die durch eine Zündschaltung gezündet wird beim Überschreiten einer an der Schaltung anliegenden vorgebbaren Maximalspannung,
— eine Reihenschaltung aus der ersten Entladungsstrecke (V1) und mindestens einer weiteren zündbaren Entladungsstrecke (V2) vorhanden ist, welche zu der zu schützenden Schaltung (Sch) parallel geschaltet ist,
— lediglich die an einem Ende der Reihenschaltung befindliche erste Entladungsstrecke (V1) mit der Zündschaltung (Z) verbunden ist,
— der Zündstift (ZS) der weiteren Entladungsstrecke (V2) auf einem elektrischen Potential liegt, das deren Zündung ermöglicht,
— der Zündstift (ZS) über einen Zündstrombegrenzer (R3) an einen ersten Zündenergiespeicher (C1) angeschlossen ist und
— zwischen dem Zündstift (ZS) und der zugehörigen Kathode (K) der weiteren Entladungsstrecke (V2) ein Zündwiderstand (R4) angeschlossen ist, an dem nach erfolgter Zündung der ersten Entladungsstrecke (V1) die für die weitere Entladungsstrecke (V2) erforderliche Zündspannung entsteht, dadurch gekennzeichnet,
— daß zwischen dem Zündstift (ZS) der weiteren Entladungsstrecke (V2) und einem Schwellwertschalter (F1) eine ohmsche Verbindung (R3, R7) vorhanden ist derart, daß durch ein Zünden der weiteren Entladungsstrecke (V2) ein Zünden der ersten Entladungsstrecke (V1) erfolgt.

2. Schutzeinrichtung nach Anspruch 1, dadurch gekennzeichnet, daß zwischen Zündstift und Kathode jeder Entladungsstrecke eine Diode (V3, V6) geschaltet ist, die an dem Zündstift eine bezüglich der zugehörigen Kathode negative Spannung vermeidet.

3. Schutzeinrichtung nach Anspruch 1 oder Anspruch 2, dadurch gekennzeichnet,
— daß bei der ersten Entladungsstrecke (V1) zwischen Zündstift und der zugehörigen Kathode ein zweiter Zündenergiespeicher (C4) angeschlossen ist, der auf ein zum Zünden der ersten Entladungsstrecke (V1) erforderliches Potential aufgeladen ist,
— daß zwischen einem Anschlußpunkt des zweiten Zündenergiespeichers (C4) und dem Zündstift der ersten Entladungsstrecke (V1) eine Reihenschaltung aus einem Schwellwertschalter (F1) und einem Zündstrombegrenzer (R10) vorhanden ist und
— daß im Stromkreis der zu schützenden Schaltung (Sch) ein Übertrager (Ü1) vorhanden ist, dessen Sekundär wicklung durch einen Abschlußwiderstand (R11) abgeschlossen ist und bei dessen Sekundärwicklung ein Anschluß mit der Kathode der ersten Entladungsstrecke (V1) verbunden ist, während der zweite Anschluß über einen Strombegrenzer (R9) mit dem Schaltanschluß des Schwellwertschalter (F1) verbunden ist (Fig. 2).

4. Schutzeinrichtung nach einem der vorhergehenden Ansprüche, dadurch gekennzeichnet, daß der Schwellwertschalter (F1) als Funkenstrecke ausgebildet ist.

**Claims**

1. Protective equipment against flash-over in a transmitter circuit, in which
— an ignitable first discharge path is connected into a branch parallel to a circuit to be protected and is ignited by an ignition circuit on a predeterminable maximum voltage present across the circuit being exceeded.
— a series connection of the first discharge path (V1) and at least one further ignitable discharge path (V2) is present, which is connected in parallel with the circuit (Sch) to be protected,
— merely the first discharge path (V1) disposed at one end of the series connection is connected with the ignition circuit (Z),
— the ignition electrode (ZS) of the further discharge path (V2) lies at an electric potential which enables the ignition of that path,
— the ignition electrode (ZS) is connected by way of an ignition current limiter (R3) to a first ignition energy store (C1) and
— an ignition resistor (R4), across which the ignition voltage required for the further discharge path (V2) arises after ignition of the first discharge path (V1) has taken place, is connected between the ignition electrode (ZS) and the associated cathode (K) of the further discharge path (V2), characterised thereby,
— that a resistive connection (R3, R7) is present between the ignition electrode (ZS) of the further discharge path (V2) and a threshold value switch (F1) in such a manner that an ignition of the first discharge path (V1) takes place through an ignition of the further discharge path (V2).

2. Protective equipment according to claim 1, characterised thereby, that a diode (V3, V6), which at the ignition electrode prevents a voltage which is negative with respect to the associated cathode, is wired between the ignition electrode and the cathode of each discharge path.

3. Protective equipment according to claim 1 or claim 2, characterised thereby

— that a second ignition energy store (C4), which is charged to a potential required for the ignition of the first discharge path (V1), is connected between the ignition electrode and the associated cathode in the first discharge path (V1),

— that a series connection of a threshold value switch (F1) and an ignition current limiter (R10) is present between a connection point of the second ignition energy store (C4) and the ignition electrode of the first discharge path (V1) and

— that a transformer (Ü1), the secondary winding of which is terminated by a terminating resistor (R11) and at the secondary winding of which one terminal is connected with the cathode of the first discharge path (V1), while the second terminal is connected by way of a current limiter (R9) with the switching connection of the threshold value switch (F1), is present in the current circuit of the circuit (Sch) to be protected.

4. Protective equipment according to one of the preceding claims, characterised thereby that the threshold value switch (F1) is constructed as spark gap.

**Revendications**

1. Dispositif de protection contre les claquages dans un circuit émetteur, où

— est montée en parallèle au circuit à protéger une première voie de décharge qui est amorcée par un circuit d'amorçage en cas de dépassement d'une tension maximale déterminée aux bornes du circuit,

— il existe un circuit en série composé de la première voie de décharge (V1) et d'au moins une autre voie de décharge (V2) amorçable, monté en parallèle avec le circuit à protéger (Sch),

— seule la première voie de décharge (V1) se trouvant à l'une des extrémités du circuit en série est reliée au circuit d'amorçage (Z),

— l'électrode d'amorçage (ZS) de la seconde voie de décharge (V2) se trouve à un potentiel permettant l'amorçage,

— l'électrode d'amorçage (ZS) est reliée par un limiteur de courant d'amorçage (R3) à un premier accumulateur d'énergie d'amorçage (C1),

— entre l'électrode d'amorçage (ZS) et la cathode correspondante (K) de la seconde voie de décharge (V2) se trouve montée une résistance d'amorçage (R4) aux bornes de laquelle, après l'amorçage de la première voie de décharge (V1), est produite la tension d'amorçage nécessaire pour la seconde voie de décharge (V2),

caractérisé en ce qu'il existe entre l'électrode d'amorçage (ZS) de la seconde voie de décharge (V2) et un circuit de seuil (F1) une liaison ohmique (R3, R7) telle que l'amorçage de la seconde voie de décharge (V2) provoque l'amorçage de la première voie de décharge (V1).

2. Dispositif de protection selon la revendication 1, caractérisé en ce que, entre l'électrode d'amorçage et la cathode de chaque voie de décharge, se trouve montée une diode (V3, V6) qui empêche l'apparition à l'électrode d'amorçage d'une tension négative par rapport à la cathode correspondante.

3. Dispositif de protection selon la revendication 1 ou 2, caractérisé en ce que

— sur la première voie de décharge (V1), entre l'électrode d'amorçage et la cathode correspondante, est monté un second accumulateur d'énergie d'amorçage (C4) qui est chargé au potentiel nécessaire pour amorcer la première voie de décharge (V1),

— entre un point de raccordement du second accumulateur d'énergie d'amorçage (C4) et l'électrode d'amorçage de la première voie de décharge (V1) se trouve le montage en série composé d'un circuit de seuil (F1) et d'un limiteur de courant d'amorçage (R 10),

— le circuit de courant du circuit à protéger (Sch) comprend un transmetteur (Ü1) dont le bobinage secondaire est terminé par une résistance de terminaison (R11) et dont le premier raccordement du bobinage secondaire est relié à la cathode de la première voie de décharge (V1), tandis que le second est relié par un limiteur de courant (R9) à la broche de commande du circuit de seuil (F1) (figure 2).

4. Dispositif de protection selon l'une des revendications précédentes, caractérisé en ce que le circuit de seuil (F1) est un éclateur.

Fig.1

Fig.2

Fig.3